Europäisches Patentamt

European Patent Office

Office européen des brevets

(11) Veröffentlichungsnummer: **0 478 909 B1**

(12) **EUROPÄISCHE PATENTSCHRIFT**

(45) Veröffentlichungstag der Patentschrift: **25.01.95**

(21) Anmeldenummer: **91112188.7**

(22) Anmeldetag: **20.07.91**

(51) Int. Cl.⁶: **C23C 16/26**, C23C 16/50, C23C 16/44

(54) Verfahren zur Herstellung einer Diamantschicht und Anlage hierfür.

(30) Priorität: **14.09.90 DE 4029270**

(43) Veröffentlichungstag der Anmeldung:
**08.04.92 Patentblatt 92/15**

(45) Bekanntmachung des Hinweises auf die
Patenterteilung:
**25.01.95 Patentblatt 95/04**

(84) Benannte Vertragsstaaten:
**AT CH DE ES FR GB IT LI NL SE**

(56) Entgegenhaltungen:
**EP-A- 0 115 970**
**GB-A- 2 176 808**
**GB-A- 2 178 228**
**US-A- 4 731 255**

**PATENT ABSTRACTS OF JAPAN, vol. 14, no.
431 (C-759)(4374), 17. September 1990; & JP-
A-21 67 891**

**PATENT ABSTRACTS OF JAPAN, vol. 9, no.
271 (C-311)(1994), 29. Oktober 1985; & JP-
A-60 118 693**

(73) Patentinhaber: **BALZERS AKTIENGESELL-
SCHAFT**

**FL-9496 Balzers (LI)**

(72) Erfinder: **Karner, Johann, Dr.
Lehrer Frick Strasse 10 A
A-6800 Feldkirch (AT)**
Erfinder: **Bergmann, Erich, Dr.
Sarganserstrasse 58
CH-8887 Mels (CH)**
Erfinder: **Daxinger, Helmut
Melserstrasse
CH-7323 Wangs (CH)**

(74) Vertreter: **Troesch Scheidegger Werner AG
Patentanwälte,
Siewerdtstrasse 95,
Postfach
CH-8050 Zürich (CH)**

JOURNAL OF APPLIED PHYSICS, Bd. 66, Nr. 10, 15. November 1989, NEW-YORK, US, Seiten 4676-4684; P.J. KUNG ET AL: "GROWTH OF DIAMOND THIN FILMS BY SPIRALHOLLW CATHODE PLASMA-ASSISTED CHEMICAL VAPOR DEPOSITION"

## Beschreibung

Die vorliegende Erfindung betrifft ein Verfahren zur Herstellung einer Diamantschicht auf einem Gut mittels reaktivem, plasmaunterstütztem Beschichtungsverfahren, eine Vakuumbehandlungsanlage für die Erzeugung von Diamantschichten mit einem Vakuumrezipienten, einer darin einmündenden Einlassanordnung für ein mindestens teilweise im Rezipienten zur Reaktion gebrachtes Arbeitsgas und einer Absauganordnung für gasförmige Reaktionsprodukte sowie ein Verfahren zur Temperatureinstellung an einem Halterungselement für ein Diamant-zu-beschichtendes Gut in einer Plasmabeschichtungskammer.

In den vergangenen Jahren wurden zahlreiche Verfahren zur Diamantbeschichtung vorgeschlagen und erprobt. Es wird hierzu auf den Uebersichtsartikel S. Matsumoto, Proceedings First International ECS Symposium on Diamond and diamond-like films, Los Angeles 1989, hingewiesen.

Die einzelnen bekannten Verfahren weisen derart schwerwiegende Probleme auf, dass es bis heute nach unserem Wissen nicht gelungen ist, Anlagen zu bauen, die eine Diamantbeschichtung im grosstechnischen Rahmen gestatteten. Bei vielen der bekannten Verfahren wird eine in der Nähe des Substrates befindliche Glühwendel verwendet. Dabei müssen sehr dünne Drähte mit Durchmessern < 1mm im Abstand von 1 bis 2cm von dem zu beschichtenden Gut oberflächenpositioniert werden und auf ca. 2000°C gehalten werden.

Abgesehen davon, dass es grosse Probleme stellt, mit einer derartigen Anordnung ausgedehnte Oberflächen, wie von Ziehmatrizen oder Werkzeugstempeln, zu beschichten, ist die Lebensdauer der erwähnten Glühwendeln aufgrund ihrer Beteiligung am Reaktionsprozess mit dem Arbeitsgas gering.

Auch bei anderen Verfahren, bei welchen die Plasmaerzeugung mittels Mikrowellen oder RF-Entladungen vorgenommen wird, ergeben sich insbesondere dann Probleme, wenn grössere Oberflächen, beispielsweise grösser als 400mm$^2$, diamantbeschichtet werden sollen.

Beim Einsatz von Gleichspannungsglimmentladungen zur Plasmaerzeugung ergibt sich das mit diesen Techniken immer wieder erwiesene Problem, dass es nicht oder nur schwer möglich ist, eine gleichmässige Plasmadichteverteilung auf Oberflächen von Formkörpern zu erzielen. Für die Erzeugung von Diamantschichten hängt aber deren Qualität sehr kritisch von der Plasmadichtenverteilung in unmittelbarer Nähe der zu beschichtenden Oberfläche ab.

Aus der US-A-4 851 254 sind ein Verfahren und eine Anlage bekannt geworden, um Diamantschichten zu erzeugen. In einem Vakuumrezipienten wird über eine Anoden/Kathodenstrecke eine Gleichspannungs-Bogenentladung erzeugt zur Bildung eines Plasmas und ausserhalb der Kathoden/Anodenstrecke das zu behandelnde Gut angeordnet. Bezüglich der Kathoden/Anodenstrecke, dem zu behandelnden Gut abgewandt, wird punktuell das Arbeitsgas für den reaktiven plasmaunterstützten Beschichtungsprozess eingelassen.

Aufgrund der Versetzung des Gutes bezüglich der Kathoden/Anodenstrecke und somit bezüglich des dazwischenliegenden Maximums der Plasmadichte gelingt es, das Gut auf tieferen Temperaturen zu halten, so dass erst mit zusätzlicher Heizung eine Guttemperatur in der Grössenordnung von 800°C während der Beschichtung eingestellt werden kann.

Die Bogenentladung erfolgt bei tiefen Spannungen, aufgrund des geringen Anoden/Kathodenabstandes bei ca. 20V und bei hohen Strömen in der Grössenordnung von 40A. Die Anordnung des Gutes wird aber weit ausserhalb des durch diesen Bogen erzeugten Plasmas hoher Leistungsdichte angeordnet.

Mithin wird die so erzeugte Plasmadichte gar nicht für den Beschichtungsprozess ausgenützt. Der Prozess wird bei etwa 3500Pa Prozessatmosphärendruck durchgeführt.

Bei dieser Anordnung ist es nachteilig, dass trotz des hohen Druckes nur eine äusserst kurze Anoden/Kathodenstrecke mit entsprechend kurzem Plasmaraum ausgenützt wird und dass das grössere Gut, ausserhalb der Entladungsstrecke angeordnet, nur in einem kleinen Bereich homogen beschichtet wird oder so weit von der fast Punkt-Entladungsstrecke angeordnet werden muss, dass es geheizt werden muss.

Aus der US-A-4 859 490 ist es weiter bekannt geworden, Diamantschichten durch plasmaunterstütztes, reaktives Beschichten dadurch zu erzeugen, dass in einem Vakuumrezipienten eine Glühwendel angeordnet wird, welche bezüglich eines Gitters auf kathodisches Gleichspannungspotential gelegt ist. Der Glühwendel bezüglich des Gitters abgewandt, ist ein Guthalter vorgesehen, der bezüglich dem anodisch betriebenen Gitter wiederum auf kathodisches Potential gelegt ist.

Arbeitsgas wird zentral an der Glühwendel vorbeigeführt, so dass an der Kathoden/Anodenstrecke, gebildet durch die Glühwendel und Gitter, das Plasma mit Dichtemaximum gebildet wird. Da das Gut mit dem kathodisch beschalteten Kalter hierfür ausserhalb der eigentlichen Anoden/Kathodenstrecke liegt und mithin wiederum ausserhalb des Bereiches höchster Plasmadichte, ergeben sich relativ tiefe Behandlungstemperaturen zwischen 600°C und 1200°C.

Der Prozessdruck wird zwischen 700 und 28000Pa angegeben.

Dieses Vorgehen weist folgende Nachteile auf: Wie bereits eingangs erwähnt, ist auch hier die Glühwendel dem Arbeitsgas ausgesetzt, was einerseits deren Standzeit wesentlich reduziert und weiter eine in ihrer Ausdehnung kleine Kathodenfläche ergibt, so dass die konische Ausdehnung des Plasmas erst durch das anodische Gitter erfolgt, mit entsprechender Abnahme der Plasmadichte, insbesondere auch am Ort des Gutes.

Aus dem Artikel "Diamond Film Preparation by Arc Discharge Plasma Jet, Chemical Vapor Deposition in the Methane Atmosphere" von Naoto Ohtake and Masanori Yoshikawa, J. Electrochem.Soc., Vol. 137, No. 2, Febr. 1990, ist es bekannt geworden, eine Diamantbeschichtung mit Hilfe eines Plasmastrahles zu erzeugen. An einer Düsenkathode wird Gas mit Ueberschallgeschwindigkeit ausgedüst, und es wird an der Kathoden/Anodenstrecke mit rechtwinklig zur Kathode versetzter Anode das Plasma gebildet und, aufgrund des Düsenimpulses, linear gegen das Gut gesprüht. Das Gut wird intensiv gekühlt, da es ansonsten aufgrund der hohen Plasmastrahltemperatur schmilzt.

Bei diesem Vorgehen ist nebst der vorzusehenden Kühlung ein hoher Aufwand für die Erzeugung des Plasmastrahles zu treiben, und es können nur relativ kleine Oberflächenbereiche des Gutes beschichtet werden, aufgrund der beschränkten Ausdehnung des Plasmastrahles.

Aus dem Artikel "Diamond Synthesis by Hollow Cathode Plasma Assisted Chemical Vapor Deposition" von B. Singh, O.R. Mesker et al., SPIE Vol. 877 Micro-Optoelectronic Materials (1988), ist es bekannt, eine Diamantschicht mittels plasmaunterstütztem reaktivem Beschichten in einem Vakuumrezipienten dadurch zu bilden, dass zwischen einer Hohlkathode und einem Anodengitter ein sich ähnlich zum Vorgehen gemäss der US-A-4 859 495 aufweitender Plasmakegel gebildet wird und ein zu beschichtendes Gut, bezüglich des Anodengitters der Kathode abgewandt, angeordnet und auf Anodenpotential gelegt wird.

Abgesehen davon, dass hier, im Unterschied zur US-A-4 859 490, keine Glühwendel eingesetzt wird, mit den im Zusammenhang mit der letzterwähnten Schrift abgehandelten Nachteilen, weist dieses Vorgehen dieselbe Nachteile auf bezüglich Plasmadichte. Da auf Anodenpotential gelegt, muss das Gut bei hohen Entladeströmen gekühlt werden.

Die vorliegende Erfindung setzt sich nun zum Ziel, ein Verfahren eingangs genannter Art sowie eine entsprechende, hierfür ausgelegte Anlage zu schaffen, welches

- kostengünstig ist,
- zuverlässig beherrschbar ist und sich ohne weiteres
- für grossflächige Beschichtungen ausbauen lässt sowie für dreidimensionale Gutbeschichtung.

Zu diesem Zwecke zeichnet sich das genannte Verfahren nach dem kennzeichnenden Teil von Anspruch 1 aus.

Eine erfindungsgemässe Anlage hierfür zeichnet sich nach dem Wortlaut von Anspruch 29 aus.

Grundsätzlich wird mit den darin aufgeführten Merkmalen erreicht:

a) dass aufgrund der eingebrachten Ladungsträger die Bogenentladung bei im wesentlichen gleich tiefen Entladungsspannungen wie bei Gleichspannungs-Bogenentladungen ohne Ladungsträgereinschuss und bei gleichen Druckverhältnissen, aber an einer wesentlich längeren Anoden/Kathodenstrecke erzeugt werden kann, womit bereits eine Grundlage geschaffen ist, grosse Oberflächenbereiche diamantzubeschichten;

b) dass aufgrund der Anordnung des zu behandelnden Gutes zwischen Anode und Kathode der Bereich höchster Plasmadichte ausgenützt wird, zudem ein Bereich grösstmöglicher Plasmahomogenität, bei einer Behandlungstemperatur im Bereich von 800 °C. Gegebenenfalls durch Steuerung eines über das Gut abfliessenden Stromes auf einen erwünschten Wert, kann die Guttemperatur eingestellt bzw. geregelt werden.

c) Durch Einbringen des Gutes in die Kathoden/Anodenstrecke wird die dort herrschende Plasmadichte grossflächig ausgenützt.

Bevorzugte Ausführungsvarianten des erfindungsgemässen Diamantbeschichtungsverfahrens sind in den Ansprüchen 2 bis 28 spezifiziert.

Aus der GB-A-2 178 228 ist es weiter bekannt, die Temperatur von niederspannungs-bogenentladungs-unterstützt beschichteten Werkstücken durch Steuerung des von ihnen abfliessenden Stromes zu beeinflussen.

Aus der CH-A-664 768 ist ein allgemeines Beschichtungsverfahren sowie eine hierfür vorgesehene Anlage bekannt geworden, wonach eine Niederspannungs-Bogenentladung erzeugt wird, indem eine Oeffnungsanordnung vorgesehen ist, durch welche ein Strom geladener Teilchen in die Anoden/Kathodenstrecke eingekoppelt wird, an welcher die Bogenentladung unterhalten wird.

Bei dem hier dargestellten, reaktiven plasmaunterstützten Beschichtungsverfahren wird Arbeitsgas mit zur Reaktion zu bringendem Gasanteil linienförmig in den Behandlungsrezipienten eingedüst. Ein Träger für zu beschichtendes Gut ist ausserhalb der Anoden/Kathodenstrecke angeordnet.

Die der vorliegenden Erfindung zugrundegelegte Vakuum-Diamantbeschichtungsanlage geht von der Einsicht aus, dass diese bekannte Art Bogenentladungserzeugung sich ausgezeichnet zur Lösung der oben gestellten Aufgabe eignet, wenn das zu beschichtende Gut in die Anoden/Kathodenstrecke eingeführt wird, also in den Bereich grösster Plasmadichte.

Mit dieser erfindungsgemässen grundsätzlichen Aenderung wird die aus der CH-A-664 768 bekannte Beschichtungsanordnung für das Diamantbeschichten geeignet.

Weitere bevorzugte Ausführungsvarianten einer solchen Anlage sind in den Ansprüchen 34 bis 50 spezifiziert.

Die Erfindung wird anschliessend beispielsweise anhand von Figuren der Beschichtungsanlage und von Beispielen zur Erzeugung der Diamantschichten erläutert.

**Es zeigen:**

Fig. 1    schematisch eine erste Ausführungsvariante einer erfindungsgemässen Anordnung für die Durchführung des erfindungsgemässen Diamantbeschichtungsverfahrens,

Fig. 1a   ein für sich erfinderisches Temperatursteuerverfahren bei der Diamantbeschichtung, anhand einer Halterung für zu beschichtendes Gut, wie in Fig. 1 vorgesehen, gezeigt,

Fig. 2    eine zweite, erfindungsgemäss verwendete Anordnung, schematisch dargestellt,

Fig. 3    schematisch eine Kombination der Vorgehensweisen nach den Fig. 1 und 2, gezeigt an einer schematischen Blockdarstellung,

Fig. 4    schematisch einen Längsschnitt durch eine bevorzugte Anordnung, dem Vorgehen nach Fig. 3 folgend, für die Diamantbeschichtung,

Fig. 5    eine detailliertere Ausführungsvariante in Längsschnitt der Anordnung nach Fig. 4, wie sie derzeit für die Diamantbeschichtung bevorzugt eingesetzt wird,

Fig. 6    schematisch eine weitere Ausführungsvariante einer für die Diamantbeschichtung eingesetzten Anlage, dem Prinzip nach Fig. 3 folgend und zum Teil mit der Ausführung gemäss den Fig. 4 und 5 übereinstimmend,

Fig. 7    schematisch die an einer erfindungsgemäss eingesetzten Anordnung elektrisch betriebenen Aggregate und deren Einstell- bzw. Steuerungsvarianten anhand eines Funktionsblockdiagrammes.

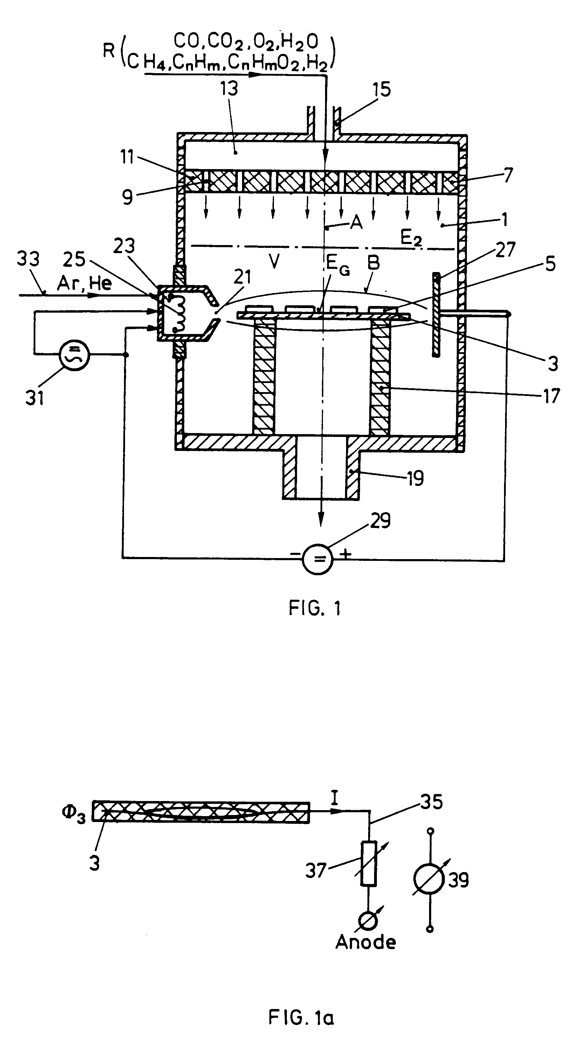

In Fig. 1 ist schematisch eine erste Ausführungsvariante einer Behandlungskammer zur Diamantbeschichtung dargestellt.

In einem Vakuumbehandlungsrezipienten 1 ist auf einer Halterung 3 das zu beschichtende Gut 5 in Form eines oder, wie dargestellt, mehrerer Werkstücke abgelegt. Die Halterung 3 definiert für das zu beschichtende Gut eine Ablagefläche, hier eine Ablageebene $E_G$. Der Halterung 3, und mithin der Fläche $E_G$ gegenüberliegend, ist am Rezipienten 1 eine Einlassanordnung 7 vorgesehen für das Arbeitsgas bzw. -gasgemisch R mit Reaktionsgas bzw. -gasgemisch.

Die Einlassanordnung 7 umfasst eine flächig verteilte Anordnung von Einlassöffnungen 9 in einer Platte 11, welche aus einer Druckausgleichskammer 13 gespiesen werden, die, bezüglich der Platte 11 vom Reaktionsraum V des Rezipienten 1 abgewandt, selbst durch eine oder mehrere Zuführleitungen 15 gasgespiesen ist.

Im dargestellten Ausführungsbeispiel ist die Halterung 3 tischartig ausgebildet und an der Rezipientenwandung mittels Isolationen 17 abgestützt. Unterhalb der Halterung 3 ist eine Absaugleitung 19 zur Evakuierung des Rezipienten 1 sowie, während des Behandlungsprozesses, zum Absaugen gasförmiger Reaktionsprodukte bzw. von verbrauchtem Arbeitsgas vorgesehen.

Durch eine Blendenöffnung 21 mit dem Reaktionsraum V des Rezipienten 1 kommunizierend, ist eine Heisskathodenkammer 23 vorgesehen, worin eine direkt oder indirekt beheizte Heisskathode 25 angeordnet ist. Der Blendenöffnung 21 gegenüberliegend ist im Rezipienten 1 eine Anode 27 vorgesehen.

Wie schematisch dargestellt, wird zwischen Heisskathode 25 und Anode 27 eine zur Unterhaltung einer Bogenentladung B notwendige Gleichspannung angelegt, mittels eines Gleichspannungsgenerators 29. Die Beheizung der Heisskathode 25 erfolgt, bei elektrischer Beheizung, mittels eines Generators 31. Bei diesem Generator kann es sich um einen Gleich- oder Wechselstromgenerator, gegebenenfalls mit nachgeschaltetem Trenntransformator, handeln.

Das Volumen der Druckausgleichskammer 13 ist so gross, dass sich darin bezüglich der Einlassöffnungen 9 eine gleichförmige Druckverteilung des durch die Leitung 15 zugeführten Gases ergibt, und durch Verteilung der Einlassöffnungen, deren Strömungsquerschnitte sowie ihre axiale Länge, mithin über ihre strömungswiderstände und ihre Mündungsrichtung, wird gezielt eine erwünschte, im wesentlichen gerichtete Einströmungsverteilung des Gases in den Rezipienten 1 bewirkt.

Im dargestellten Beispiel wird durch Gleichverteilung und Gleichausbildung der Oeffnungen 9 an der Platte 11 eine im wesentlichen gleichförmige, gegen die Halterung 3 gerichtete Gasausströmung erzielt. Das in den Reaktionsraum V eingelassene Arbeitsgas reagiert teilweise darin zu einem in der Zeit zunehmenden Anteil, und verbrauchtes Arbeitsgas wird durch Leitung 19 abgesaugt.

Durch den verteilten Arbeitsgaseinlass und die im wesentlichen zu diesem Einlass zentrale Absaugung 19 ergeben sich im Reaktionsraum V entlang strichpunktiert eingetragener Flächen $E_2$ je im wesentlichen gleiche Verhältnisse unverbrauchten Arbeitsgases zu verbrauchtem Arbeitsgas. Dadurch, dass durch die Halterung 3 das zu beschichtende Gut auf einer solchen Fläche positioniert wird, wird eine gleichförmige Beschichtungswirkungsverteilung mindestens auf zu dieser Fläche aequidistanten Oberflächenbereichen des Gutes erzielt.

Durch die erwähnte Ausrichtung und Ausbildung der Einlassöffnungen 9 wird, zusammen mit der Anordnung der Absaugung, die Form der erwähnten Aequi-Verteilungsflächen $E_2$ wesentlich mitbestimmt, welche im dargestellten Beispiel zueinander parallele Ebenen sind. Da im hier dargestellten Beispiel nur in einem kleinen Volumenbereich eine Bogenentladung B unterhalten wird, ist deren Wirkung nicht im ganzen Reaktionsraum V gleich.

Der Rezipient 1 wird vorzugsweise allseits aus einem den Beschichtungsprozess nicht beeinträchtigenden Material gebildet, vorzugsweise aus Quarzglas.

Die Halterung 3 und mithin das Gut werden vorzugsweise in einer Variante nicht auf ein bestimmtes elektrisches Potential gelegt, sondern, wie mit den isolierenden Stützen 17 dargestellt, potentialfliegend betrieben, so dass sich daran ein elektrisches Potential einstellen kann gemäss der Potentialverteilung im Reaktionsraum V. Dadurch wird die Beschichtungstemperatur des Gutes abgesenkt, gegenüber dem Fall, in dem das Gut auf Anodenpotential gehalten würde.

Auf diese Art und Weise ist in einem ersten Schritt bereits eine gezielte Diamantbeschichtung von grossflächigem Gut möglich, durch ein reaktives, bogenplasma-unterstütztes Verfahren. Bei der auf gezeigte Art erzeugten Bogenentladung handelt es sich um eine lange Niederspannungsentladung, die bei Drücken nur einiger Pa mit einer tiefen Gleichspannung, z.B. unterhalb 150V, üblicherweise bei Spannungen von der Grössenordnung der Ionisierungsenergie des Arbeitsgasgemisches, unterhalten wird.

Um zu verhindern, dass das im Reaktionsraum zur Reaktion gebrachte Gas mit der Heisskathode 25 in Kontakt tritt, deren Material dann den Beschichtungsprozess beeinflussen und mitreagieren würde, womit ihre Lebensdauer auch drastisch verringert würde, wird in der Kathodenkammer 23 bevorzugterweise, z.B. durch eine Leitung 33, ein Spülgas eingelassen. Dabei kann der Druck in der Kathodenkammer 23 so eingestellt werden, dass er geringfügig höher ist als der Arbeitsdruck im Reaktionsraum V, womit eine Gasausströmung aus Kammer 23 erzielt wird.

Beim Betrieb von Niederspannungsentladungen mit Heisskathoden ist es wesentlich, dass ein neutraler Plasmastrom von der Ionisationskammer in die Beschichtungskammer austritt, also eine gleiche Anzahl Ionen wie Elektronen. Als Spülgas wird auf jeden Fall ein prozesskompatibles Gas eingeführt, üblicherweise Edelgase, Ar oder He.

Mit den so erzeugten Niederspannungsbogen wird ein Plasma mit relativ niedriger Gastemperatur - bei hoher Elektronentemperatur - in der Grössenordnung von 200°C bis 1000°C erzeugt. Dies erlaubt es, das Gut zwischen Kathode und Anode anzuordnen, was für den Diamantbeschichtungsprozess, der eine hohe Plasmadichte bei tiefen Guttemperaturen erfordert, ausserordentlich vorteilhaft ist.

In Fig. 1a ist ausschnittsweise die Halterung 3 von Fig. 1 dargestellt. Wie erwähnt wurde, stellt sich, bei einer bevorzugten Variante, aufgrund der potentialfliegenden Montage der Halterung 3 daran ein entsprechend der Potentialverteilung im Reaktionsraum V herrschendes, elektrisches Potential $\Phi_3$ ein. Nun wird in einer Weiterentwicklung der in Fig. 1 dargestellten Anordnung die Halterung 3 vorzugsweise durch einen Stromzweig 35, über ein Widerstandselement 37, mit einem Bezugspotential, beispielsweise Anodenpotential, verbunden. Damit stellt sich nach Massgabe der Impedanzverhältnisse im Reaktionsraum V und den Wert des Widerstandselementes 37 über letzterem eine Potentialdifferenz ein, und der dadurch getriebene Strom I wird als Temperatursteuergrösse für die Temperatur der Halterung und mithin des Gutes eingesetzt.

Alternativ dazu kann das Potential des Gutes, entkoppelt vom Bogenstrom, durch eine verstellbare Spannungsquelle 39 zwischen Anoden- und Kathodenpotential im Raum V verstellt werden. Diese beiden Vorgehen eignen sich insbesondere für die Feineinstellung oder die Regelung der Guttemperatur, was beim erfindungsgemässen Beschichtungsverfahren wesentlich ist. Zum Stellen des "Heizstrom"-Wertes I wird der Widerstandswert um einen Arbeitspunkt herum verstellt.

Auch durch Verstellen des Gutpotentials, entkoppelt von der Entladung, wird die Guttemperatur verstellt.

Zur Temperaturregelung wird, wie dem Fachmann nun ohne weiteres klar, die Temperatur der Halterung 3 abgegriffen, ein ihr entsprechendes elektrisches Signal mit einem Sollwert verglichen, und Widerstandswert des Widerstandselementes 37 und/oder Spannungswert an der Spannungsquelle 39 je als Stellglieder regelnd gestellt.

Durch Variation des Sollwertes während des Behandlungsprozesses kann die Guttemperatur im Sinne einer Führungsregelung einer vorgegebenen Zeitcharakteristik nachgeführt werden.

Ausgehend von der Anordnung nach Fig. 1 ergeben sich nun folgende Weiterentwicklungsschritte für eine Anlage zur Diamantbeschichtung:

- anstelle oder zusätzlich zum gezielt verteilten Arbeitsgaseinlass, das Erzeugen einer gezielt verteilten, langen Niederspannungs-Bogenentladung,
- eine wesentliche Erhöhung der Ausnützung des Volumens des Reaktionsraumes V durch Anordnen von zu beschichtendem Gut auf mehreren Verteilungsflachen $E_2$.

Die Absaugung 19 braucht nicht zentral vorgenommen zu werden, sondern kann auch peripher und/oder verteilt erfolgen.

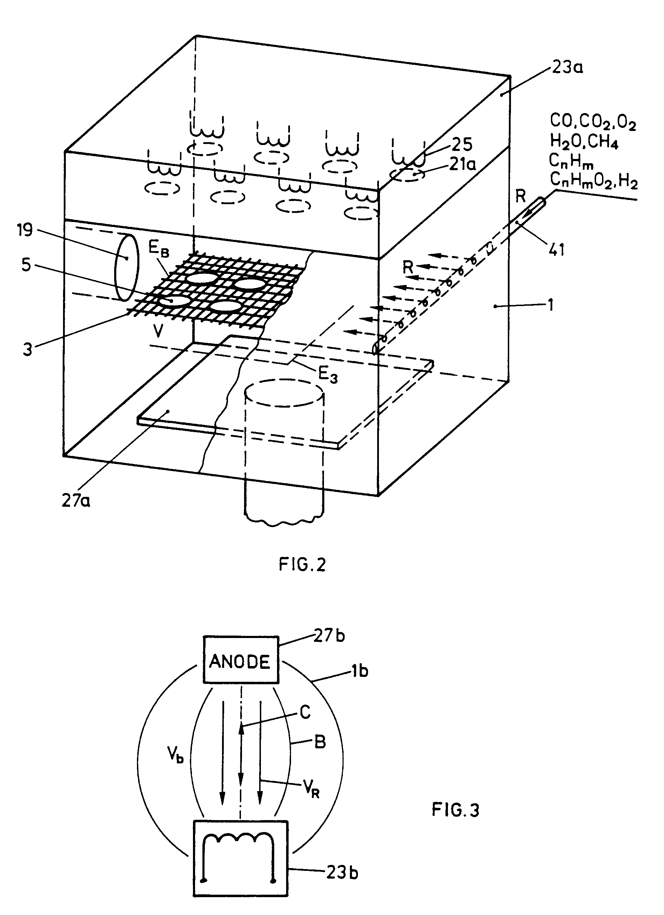

In Fig. 2 ist schematisch eine weitere Anlage dargestellt. Hier wird nicht der Gaseinlass gezielt verteilt ausgebildet, sondern die Bogenentladung.

In Fig. 2 dargestellte Komponenten, die bereits bei der Ausführungsvariante gemäss Fig. 1 erläutert wurden, sind mit den gleichen Positionsnummern versehen.

Am Beschichtungsrezipienten 1, hier kubisch ausgebildet, welchem über eine endständig gelochte Zuführleitung 41, in diesem Falle nicht flächig verteilt, das Arbeitsgas R zugeführt wird, ist eine Heisskathodenkammeranordnung 23a vorgesehen, welche sich entlang einer Quaderwand des Rezipienten 1 erstreckt. Darin sind, flächig verteilt wirkend, ein oder mehrere Heisskathoden 25 vorgesehen.

Die Kathodenkammeranordnung 23a, bei der es sich selbstverständlich auch um einzelne getrennte Kammern, entsprechend verteilt, handeln kann, ist über mehrere Blendenöffnungen 21a mit dem Reaktionsraum V des Rezipienten 1 verbunden. Im Rezipienten ist, den Blenden 21a gegenüberliegend, die rechteckige oder quadratförmige Anode 27a angeordnet. Quer zur Entladungsrichtung ist ein Halterungsgitter 3 für zu beschichtende Güter 5 vorgesehen, die Absaugung 19 auf der der Arbeitsgaszuführung 41 zugewandten Quaderseite. Die mehreren Bogenentladungen, hier flächig verteilt, ergeben entlang Flächen $E_B$ eine für einige Beschichtungsanforderungen ausreichend gleichförmige Beschichtung, trotz der nicht flächig verteilten Arbeitsgaszuführung. Auch hier kann die Gleichförmigkeit der Beschichtung durch gezielte Verteilung der Entladungen beeinflusst werden. Mit $E_3$ sind Flächen eingetragen, entlang welchen die Plasmadichte in wesentlichen konstant ist, bei gleich verteilten und gleich betriebenen Anoden/Kathodenstrecken.

Durch gezielte flächige oder räumliche Verteilung und/oder Ansteuerung jeweils einzelner oder gruppierter Anoden/Kathodenstrecken wird im Reaktionsraum V die räumliche Plasmaverteilung beeinflusst. Somit kann mit den erläuterten langen Niederspannungsbogenentladungen die räumliche Diamantschichtverteilung entweder durch gezielt grossflächige Verteilung des Arbeitsgaseinlasses oder durch gezielte räumliche Verteilung der Bogenentladungen eingestellt werden, so dass grossflächige Güter oder gleichzeitig viele behandelt werden können, dies auch dreidimensional.

Ohne weiteres ersichtlich wird nun, dass die beiden Massnahmen gemäss Fig. 1 und Fig. 2 bevorzugterweise kombiniert werden, indem sowohl der Gaseinlass mit gezielt flächiger Verteilung vorgenommen wird wie auch die Bogenentladungen räumlich gezielt verteilt erzeugt werden. Eine solche bevorzugte Anlage wird anschliessend beschrieben.

Es hat sich gezeigt, dass die erwähnte, nach Fig. 1 bzw. 2 erzielte, vorerst zweidimensional gleiche Beschichtungsverteilung dann in eine dreidimensionale gleiche Verteilung übergeht, wenn Anoden/Kathodenstrecke und die im wesentlichen durch Ein- und Auslass gegebene Gasverbrauchsrichtung gleich bzw. gegengleich sind.

In Fig. 3 ist diese Vorgehensweise prinzipiell dargestellt, bei der eine Bogenentladung B zwischen einer Heisskathodenanordnung 23b und einer Anodenanordnung 27b in einem wesentlichen Volumenbereich eines Reaktionsraumes $V_b$ eines Rezipienten 1b in gleicher Richtung C erfolgt, wie die zwischen Arbeitsgaseinlass und Absaugung festgelegte Verbrauchsrichtung $V_R$ des Reaktionsgases. Es werden anschliessend solche bevorzugte Ausführungsbeispiele dargestellt, welche, kombiniert, die Vorgehensweisen nach Fig. 1, 2 und 3 aufzeigen.

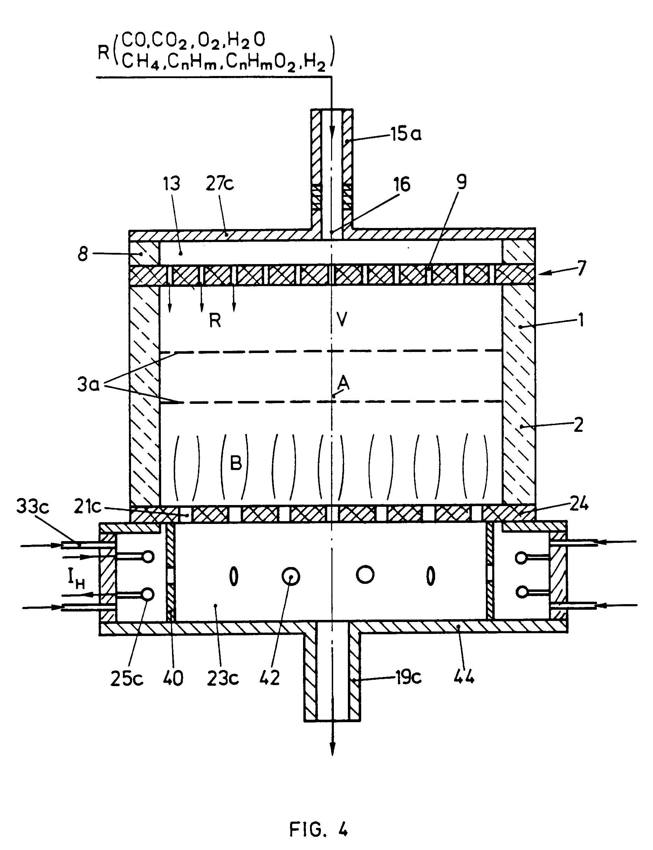

In Fig. 4 ist, schematisch, der grundsätzliche Aufbau einer ersten Ausführungsvariante dargestellt. Der Rezipient 1 weist eine Zylinderwandung 2, aus Quarz, auf. Abgeschlossen wird der von der Wandung 2 begrenzte Reaktionsraum V einerseits durch die Einlassanordnung 7 mit Oeffnungen 9 für frisches Arbeitsgas R. Bezüglich Ausströmrichtung stromaufwärts, bildet eine Anodenplatte 27c mit einer elektrisch isolierenden Wandungspartie 8 die Druckverteilkammer 13, wobei das frische Arbeitsgas R durch einen Leitungsanschluss 15a mit Zentrumseinmündung 16 durch die Anodenplatte 27c in die Druckverteilkammer 13 eingeführt wird.

Auf im wesentlichen senkrecht zur Rezipientenachse A ausgelegten Ebenen sind mehrere Gutträger bzw. Substratträgergitter 3a angeordnet. Auf der anderen Seite, bezüglich der Einlassanordnung 7, wird der Reaktionsraum V durch eine Blendenplatte 24 abgeschlossen, mit Austrittsblenden 21c für die schematisch eingetragenen Bogenentladungen B.

Anschliessend an die Blendenplatte 24 ist die Heisskathodenkammer 23c vorgesehen, worin beispielsweise, an der Peripherie, eine mit Heizstrom $I_H$ direkt beheizte Heisskathodenwendel 25c umläuft. Es ist, wie hier nicht mehr dargestellt, ein Niederspannungsgenerator zwischen Anodenplatte 27c und Heisskathode 25c geschaltet. Im Bereiche der Heisskathode 25c münden Spülgasleitungen 33c ein, womit ein Spülgas, wie Argon oder Helium, in den Heisskathodenbereich eingelassen wird.

Durch das in den Bereich der Heisskathode 25c eingelassene Gas wird die Kathode vor Beschichtungsprozesseinwirkungen geschützt. Dies ergibt eine wesentlich längere Standzeit der Heisskathode.

Im dargestellten Ausführungsbeispiel ist die Heisskathode 25c von einer koaxialen Blende 40 umgeben, mit radial gerichteten Oeffnungen 42. Dadurch wird eine Druckabstufung zum Zentrum hin möglich.

Stirnseitig ist die Kathodenkammer 23c durch einen Deckelteil 44 abgeschlossen, mit zentraler Absaugleitung 19c. Die Blendenplatte 24 ist gekühlt (nicht dargestellt). Der Blendenschirm 40 ist vorzugsweise aus Tantal oder einer Keramik gefertigt.

Wie erwähnt wurde, wird durch die Einlassöffnungen 9, vorzugsweise gleichförmig verteilt, das Arbeitsgas R in den Reaktionsraum V eingelassen. Die Bogenentladung wird aus den z.B. gleich verteilten Blendenöffnungen 21c sowie, über die Oeffnungen 9 der Anordnung 7, die Anode 27c unterhalten. Gleichzeitig strömen gasförmige Reaktionsprodukte durch die Blendenöffnungen 21c, im Gegenstrom zum Elektronenstrom der Bogenentladung, und durch den Zentralbereich der Kathodenkammer 23c aus der Absaugleitung 29c.

Die Werkstücke werden auf z.B. potentialfrei betriebenen Substratträgergittern 3a abgelegt oder, zur Temperatursteuerung bzw. -regelung über einen Stromzweig, wie anhand von Fig. 1a erläutert wurde, mit einem Bezugspotential oder einer Steuerspannungsquelle verbunden.

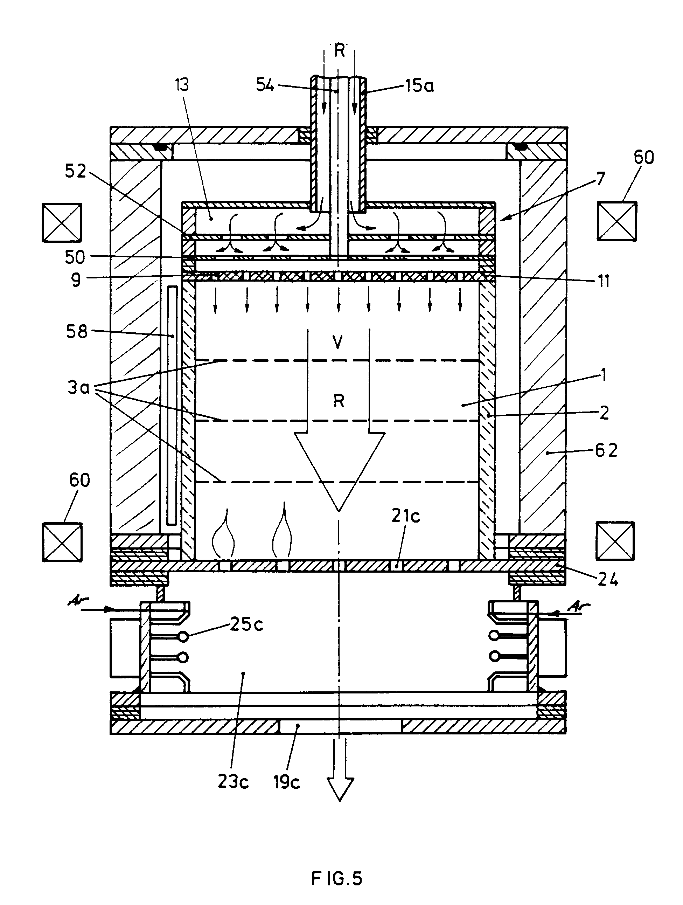

Fig. 5 ist eine derzeit bevorzugte Ausführungsvariante einer erfindungsgemäss eingesetzten Beschichtungskammer detaillierter dargestellt. Es werden bei deren Beschreibung die bereits vormals verwendeten Bezugszeichen eingesetzt für bereits beschriebene Teile bzw. Aggregate.

Der eigentliche Rezipient 1 mit Quarzglaswandung 2 wird von der Einlassanordnung 7 einseitig abgeschlossen. Hinter der Einlassplatte 11 mit Einlassöffnungen 9 für das Arbeitsgas, welche Platte hier auch aus Quarz gefertigt ist, ist eine relativ grossdurchmessrig gelochte, gekühlte Anodenplatte 50 angeordnet, bezüglich der Platte 11 beabstandet und isoliert. Wiederum von der Anodenlochplatte 50 abgesetzt, ist eine weitere Lochplatte 52 zur besseren Gasverteilung angeordnet. Im zentralen Arbeitsgaszuführungsrohr 15a ist, zentral, die elektrische Zuführung 54 für die Anode vorgesehen.

Die Druckverteilkammer wird hier durch zwei Druckstufen zwischen den beiden Verteilplatten 52 und 11 gebildet. Die Anodenplatte 50 ist für das Arbeitsgas möglichst wenig störend, "transparent" ausgebildet, um einerseits dessen Strömung nicht zu stören und um anderseits möglichst wenig durch dieses Gas beeinträchtigt bzw. störend beschichtet zu werden.

Durch diese Anordnung wird eine optimal homogene Gasverteilung an den hier gleich ausgebildeten Gaseinlässen 9 erreicht und gleichzeitig eine Kühlung der Anode 50 gewährleistet.

Gegebenenfalls können Heizstäbe 58 ausserhalb des Rezipienten 1 vorgesehen sein.

Im weiteren sind Magnetspulen 60 ausserhalb des Rezipienten und koaxial zur Anoden/Kathodenstrecke vorgesehen sein, um mittels magnetischer Gleich- oder Wechselfelder die Plasmaverteilung im Reaktionsraum V mit den Gutträgern 3a zu optimieren.

Der eigentliche Rezipient mit vorgesehenen Heizungen 58 ist durch eine Aussenwandung 62 abgeschlossen.

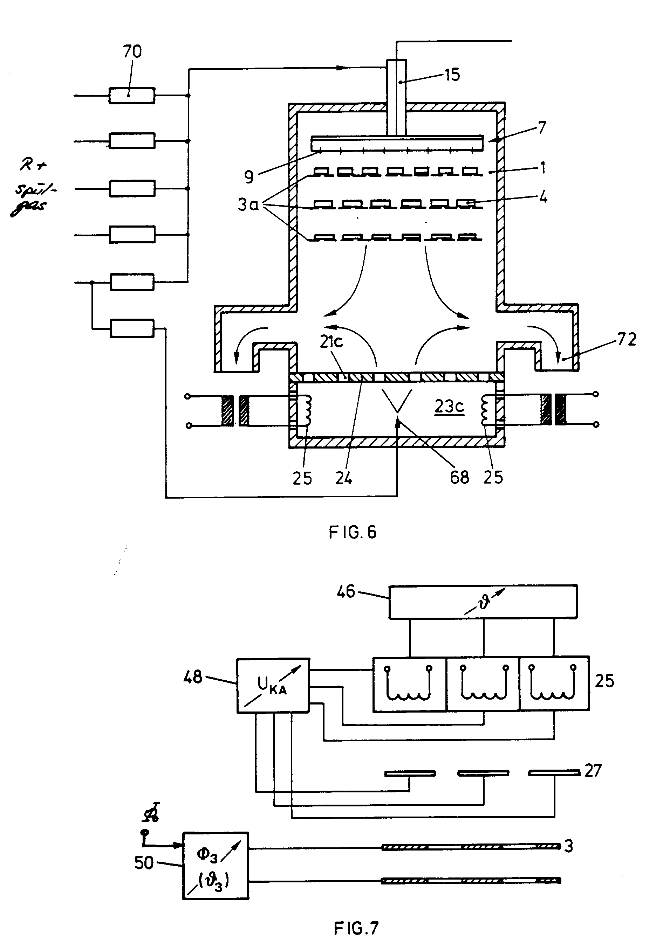

In Fig. 6 ist schematisch eine weitere, für das erfindungsgemässe Verfahren eingesetzte Beschichtungskammer dargestellt, bei der die Absaugung sowohl von Spülgas, eingelassen durch den schematisch dargestellten Einlass 68, wie auch des Arbeitsgases, eingelassen, wie beschrieben wurde, durch die Zuführung 15, peripher erfolgt. Es sind die bereits verwendeten Bezugszeichen eingesetzt, womit die hier dargestellte Anordnung dem Fachmann ohne weiteres verständlich wird.

Durch entsprechende Gestaltung der Oeffnungen in der Blenden- und Verteilplatte 24 wird in der Ionisationskammer bzw. Kathodenkammer ein höherer Druck als im Behandlungsraum eingestellt. Dadurch wird eine besonders effektive Ionisierung des Gases erzielt. Dadurch, dass das Gas in der Ionisationskammer 23 im wesentlichen ein Edelgas ist, wird die Lebensdauer der Kathode drastisch erhöht.

Mit 4 sind, schematisch, auf den Gutträgern 3a angeordnete, zu beschichtende Güter dargestellt, und 70 bezeichnet Durchflussregler, einerseits für das über Anschluss 15 zugeführte Arbeitsgas, anderseits für das über die Zuführung 68 zugeführte Spülgas.

Die Absaugung erfolgt an den Absauganschlüssen 72.

Folgende Dimensionierungen, als relativ kritische Grössen, haben sich bis anhin bewährt:

- Verteilungsdichte $D_{21}$ der Oeffnungen 21c in der Blendenplatte 24: $D_{21} \geq 10/m^2$; vorzugsweise $D_{21} \geq 50/m^2$;
- Durchmesser $\Phi_{21}$ der Oeffnungen 21c in der Blendenplatte 24: $1mm \leq \Phi_{21} \leq 8mm$;

- Dichte $D_9$ der Oeffnungen 9 in der Platte 7: $D_9 \geq 500/m^2$, vorzugsweise $D_9 \geq 2000/m^2$,
- Durchmesser $\Phi_9$ der Oeffnungen 9 in der Verteilplatte 7: $0{,}5mm \leq \Phi_9 \leq 10mm$.

In Fig. 7 sind, schematisch, die elektrisch betriebenen Anlageteile der erfindungsgemässen Anordnung dargestellt. Diese umfassen eine, oder wie dargestellt, mehrere Heisskathoden 25, eine oder mehrere Anoden 27, ein oder mehrere Gutträger 3 für zu behandelndes Gut.

Ein oder mehrere folgender Grössen können zur Optimierung des Behandlungsverfahrens eingestellt werden:

- Sofern mehrere Heisskathoden 25 vorgesehen sind, kann deren Betriebstemperatur, wie bei direkt beheizten Heisskathoden deren Heizstrom, z.B. selektiv eingestellt werden zur Optimierung der Bogenentladungsverteilung. Dies durch eine Betriebstemperatursteuereinheit 46.
- Bei Vorsehen mehrerer Anoden 27 und mehrerer Heisskathoden 25 und analog bei Vorsehen einer Heisskathode und mehrerer Anoden bzw. einer Anode und mehrerer Heisskathoden werden die jeweiligen Niederspannungswerte der Anoden/Kathodenspannungen $U_{KA}$, an einer Steuereinheit 48, zur Optimierung der Bogenentladungsverteilung z.B. selektiv eingestellt.
- Die elektrischen Betriebspotentiale der, in diesem Falle, mindestens abschnittsweise aus einem leitenden Material bestehenden Gutträger 3 werden an einer selektiven Einstelleinheit 50, sei dies mittels Spannungsquellen 39 gemäss Fig. 1a und- oder Verstellung des Widerstandswertes in einem Stromzweig 35 gemäss genannter Figur, mindestens beeinflusst, insbesondere zur Feineinstellung der Gutträgertemperatur bzw. des Elektronenbeschusses der aufwachsenden Schicht.

Die dargestellten Beschichtungsanlagen für reaktive, niederspannungsbogenplasma-unterstützte Diamantbeschichtung arbeiten mit tiefen Anoden/Kathodenspannungen, beispielsweise unterhalb 150V, mit hohen Entladungsströmen pro Gutträgerfläche, beispielsweise über 4000 $A/m^2$, und ergeben tiefe Behandlungstemperaturen, im wesentlichen unterhalb 900°C. Es ergeben sich hohe Plasmadichten bei tiefen Behandlungstemperaturen.

Es werden nun einige mittels einer Behandlungsanlage gemäss den Fig. 5 oder 6 ausgeführte Beispiele des erfindungsgemässen Diamantbeschichtungsverfahrens vorgestellt.

Beispiel 1

Mit Diamantpaste vorbehandelte Siliziumsubstrate mit den Anmessungen 20 x 10 x 1 mm wurden auf ein Substratgitter mit einem Durchmesser von 360 mm aufgelegt, das sich zwischen Kathode und Anode befand. Das Substratgitter war samt den Substraten von Kathode und Anode elektrisch isoliert. Der Beschichtungsrezipient wurde auf einen Druck von < 0,1 Pa evakuiert. Nach dem Zünden des Plasmas in reiner Argon-Atmosphäre, wobei 20% des Argons durch die Ionisierungskammer bzw. Heisskathodenkammer und 80% durch die Anode eingelassen wurden (der Ar-Fluss betrug 90% des Gesamtflusses), wurden 9% H2 durch die Anode zugegeben. Da ein Teil des Argonflusses durch die Ionisierungskammer eingelassen wurde und da zusätzlich, aufgrund der Blenden im Deckel der Heisskathodenkammer, dort ein höherer Druck als im Beschichtungsraum herrschte, waren die Heisskathoden von Argon umspült und waren nicht direkt dem H2-Fluss ausgesetzt. Dadurch wurde eine hohe Lebensdauer der Heisskathoden erreicht. So konnten diese für zwanzig 10-stündige Beschichtungsläufe verwendet werden. Die Substrate befanden sich dabei direkt im Plasma zwischen Anode und Kathode. Der Bogenstrom wurde auf ca. 650 A eingestellt - was einem Strom pro Substratträgerfläche von ca. 6,4 $kA/m^2$ entspricht -, so dass die Substrate in Plasma auf eine Temperatur von 800°C aufgeheizt wurden. Die Bogenspannung betrug 70 V, das floating-Potential der Substrate lag 35 V unter dem Anodenpotential. Nach Erreichen der Temperatur wurde 1% CH4 zu den Prozessgasen beigemischt. Die Messung der Gasflüsse der verschiedenen Gase erfolgte mit Mass-Flow Controllern. Durch Regelung des Saugvermögens der Vakuumpumpe wurde der Beschichtungsdruck auf 400 Pa eingestellt. Durch Feinregelung des Bogenstroms (Fig. 1a) wurde die Beschichtungstemperatur, die mit Thermoelementen gemessen wurde, auf 800°C gehalten. Nach einer Beschichtungszeit von 5 h wurden die Substrate abgekühlt und aus dem Rezipient entnommen.

Die so erzeugten Schichten zeigten im Rasterelektronenmikroskop zu einer dichten Schicht Zusammengewachsene scharfkantige Kristalle mit einer Korngrösse von 0,5 bis 5 $\mu$m, wobei die Kristalle vornehmlich eine [100]-Facettierung aufwiesen. Die Schichtdicke betrug 5 $\mu$m. Im Raman-Spektrum konnte der Diamantpeak bei 1333 $cm^{-1}$ nachgewiesen werden. Die aus dem Elektronenbeugungsbild einer vom Substrat abgelösten Schicht ermittelten Netzebenenabstände entsprachen den Netzebenenabständen der Diamantstruktur.

In einem weiteren Versuch wurde bei sonst unveränderten Parametern der CH4-Fluss auf 0,7% verringert. Bei einer etwas geringeren Beschichtungsrate von 0,8 μm/h wiesen die Schichten dann vornehmlich eine [111]-Facettierung auf.

Bei einem CH4-Gasfluss von 0,3% blieben die Silizium-Substrate in einem 5-stündigen Beschichtungslauf unbeschichtet, jedoch konnte eine starke Aetzung der Silizium-Oberfläche beobachtet werden. Dies zeigt, dass der CH4-Fluss so gering war, dass entstehende Keime wieder abgeätzt wurden.

Der CH4-Fluss ist im Vergleich zu anderen Diamantbeschichtungsverfahren relativ hoch, weil durch den anodenseitigen Gaseinlass ein Teil des Gases an der grossflächigen Anode verbraucht wurde. Auf dieser wird aufgrund der niedrigen Beschichtungstemperatur durch ihre intensive Kühlung eine amorphe Kohlenstoffschicht abgeschieden.

Bei einem CH4-Fluss von 2,5% konnte im Raman-Spektrum nur noch der amorphe Kohlenstoffpeak beobachtet werden. Die Schicht selbst wies auch keine im REM erkennbaren Kristalle mehr auf. Nach einstündigem Aetzen dieser Schicht in einer Ar/H2-Atmosphäre waren im REM wiederum scharfkantige Kristalle mit [100]-Facettierung zu erkennen. Dies zeigt, dass Anteile an amorphen Kohlenstoff in der Schicht wesentlich schneller geätzt werden als Diamantkristalle, die aufgrund der geringen Empfindlichkeit für Raman-Streuung im Spektrum nicht nachgewiesen werden konnten.

Beispiel 2:

Vorbehandelte Siliziumsubstrate wurden auf das Substratgitter gelegt, das über einen ohmschen Widerstand mit der Anode verbunden war. Nach dem Hochheizen in einer Ar/H2-Atmosphäre wurde wieder 1% CH4 zugegeben. Es wurde ein Bogenstrom von ca. 600 A eingestellt, entsprechend einer Stromdichte pro Substratträgerfläche von ca. 5,9 kA/m², und über den Widerstand (Fig. 1a) pro cm² Beschichtungsfläche ein Strom I von ca. 0,5 A über die Substrate und das Substratträgergitter abgezogen.

Dadurch wurde das Substratpotential von floatendem Potential in Richtung Anodenpotential angehoben, und durch Regulierung des Stroms über den variablen Widerstand konnte die Temperatur der Substrate eingestellt werden. Durch die Anhebung des Substratpotentials in Richtung Anode wurde die Energie der auf das Substrat auftreffenden Ionen verringert.

Langmuirsondenmessungen ergaben eine Elektronenenergie von 15 eV, während die Ionenenergie im Plasma wesentlich geringer war.

Die Prozesszeit betrug 5 h bei einer Beschichtungstemperatur von 800°C. Die Schichten zeigten wieder Kristalle mit [100]-Facettierung. Durch die Möglichkeit der genauen Temperaturregelung mit dem Substratträgerstrom war eine exaktere Prozessführung möglich.

Beispiel 3:

Der Beschichtungsprozess erfolgte wie in Beispiel 2, jedoch wurde das Potential der Substrate, anstelle des variablen Widerstands, durch einen zusätzlichen Gleichspannungsgenerator zwischen Kathode und Substratgitter eingestellt. Der Vorteil dieser Anordnung besteht in der Entkopplung der Plasmaleistung von der Beschichtungstemperatur: Bei konstanten Parametern des Bogens, der die Anregung der Gasteilchen bestimmt, kann unabhängig davon die Beschichtungstemperatur eingestellt werden.

Bei einem Bogenstrom von 550 A und einer Bogenspannung von 60 V war zur Erreichung der Beschichtungstemperatur von 800°C ein Strom von 0,5A pro cm² Beschichtungsfläche erforderlich. Die so abgeschiedenen Schichten wiesen eine [100]-Facettierung auf.

In einem weiteren Versuch wurden auf ein oberes Substratträgergitter Siliziumsubstrate mit den Abmessungen 15 x 20 x 1 mm aufgelegt, auf ein darunterliegendes Substratträgergitter wurden Hartmetall-Wendeschneidplatten mit den üblichen Abmessungen 12,7 x 12,7 x 2 mm aufgelegt. Da kleine Substrate im Plasma stärker aufgeheizt werden als grossflächige, war zur Einstellung der gleichen Temperatur auf den beiden Substratebenen ein unterschiedlicher Strom I (Fig. 1a) erforderlich, der durch die getrennte Spannungsversorgung der einzelnen Substratgitter eingestellt werden konnte. Sowohl auf den Siliziumsubstraten als auch auf den Wendeschneidplatten konnten Diamantschichten mit [100]-Facettierung abgeschieden werden.

Beispiel 4:

Siliziumsubstrate wurden ohne Vorbehandlung mit Schleifmitteln als Substrate verwendet. Bei einer Prozessführung wie in Beispiel 1 konnten wieder Diamantschichten abgeschieden werden, jedoch war die Keimdichte geringer als bei vorbehandelten Substraten. Es entstanden weniger, aber dafür grössere Kristalle.

Beispiel 5:

Der Beschichtungsprozess wurde bei einer Gaszusammensetzung von 60% Ar, 33% H2 und 7% CH4 bei einer Beschichtungstemperatur von 800°C durchgeführt. Bei einem Bogenstrom von 450 A betrug die Bogenspannung 100 V. Der Prozessdruck betrug 400 Pa, die Siliziumsubstrate waren auf floatendem Potential. Bei dem höheren H2-Anteil im Plasma stieg die Bogenspannung, jedoch wurde bei der erhöhten Zugabe von CH4 der Bogen instabil, so dass der Bogen mehrmals erneut gezündet werden musste.

Beispiel 6:

Keramische Wendeschneidplatten wurden bei einem Druck von 20 Pa und einer Temperatur von 780°C beschichtet. Die Gaszusammensetzung war 9% H2, 2% CH4 und 89% Ar. Der Bogenstrom betrug 620 A bei einer Bogenspannung von 70 V. In einem 10-stündigen Beschichtungslauf konnten 11μm dicke Schichten abgeschieden werden. Die Schicht bestand aus den aus der Literatur bekannten "ball-like" Diamantkristallen, die bei höheren CH4-Flüssen entstehen.

Beispiel 7:

Der Beschichtungsprozess wurde wie in Beispiel 2 durchgeführt, jedoch wurde als zusätzliches Beschichtungsgas $CO_2$ verwendet (Ar 88%, H2 9%, CH4 1%, CO2 2%). Bei einer Beschichtungstemperatur von 800°C konnte dadurch der Diamantanteil in den Schichten erhöht werden, wie aus den Raman-Spektren hervorgeht. Die so erzeugten Schichten wiesen eine ausgeprägte [111]-Facettierung auf.

Beispiel 8:

Der Beschichtungsprozess erfolgte wie in Beispiel 7, als zusätzliches Beschichtungsgas wurde aber anstelle von CO2 noch O2 verwendet. Die Gaszusammensetzung war 89% Ar, 9% H2, 1,5% CH4 und 0,5% O2. Die Schichten wiesen eine ausgeprägte [111]-Facettierung auf.

Beispiel 9:

Der Beschichtungsprozess erfolgte wie in Beispiel 1, jedoch wurden die Gase H2 und CH4 nicht durch die Anode eingelassen, sondern durch eine auf floatendem Potential liegende Gaszuführung direkt in den Beschichtungsraum. Auch in dieser Konfiguration konnten auf Siliziumsubstraten Diamantschichten abgeschieden werden. Es war ein geringerer CH4-Fluss erforderlich, weil an der Anode keine so stark ausgeprägte Gasaufzehrung erfolgte wie bei anodischem Einlass des CH4.

Beispiel 10:

Es wurde die gleiche Anordnung wie in Beispiel 1 gewählt und die gleichen Parameter eingestellt. Jedoch wurde der Bogenstrom auf 750 A geregelt, bei einer Bogenspannung von 80 V, so dass die Beschichtungstemperatur 900°C betrug.

Die so abgeschiedenen Schichten zeigten keine scharfkantigen Kristalle mehr, sondern eine weiche, graphitähnliche schwarze Schicht.

Beispiel 11:

Die Prozessführung erfolgte wie in Beispiel 3, jedoch wurde die Beschichtungstemperatur am Beginn des Beschichtungsprozesses niedriger gehalten als während des Beschichtungsprozesses. Dadurch konnte eine bessere Qualität der Kristalle in Substratnähe erzielt werden, was mittels REM-Aufnahmen nachgewiesen wurde. Dieses Beispiel zeigt, dass die optimale Beschichtungstemperatur in der Keimentstehungsphase anders ist als beim nachfolgenden Wachstumsprozess. Bei gleicher Beschichtungstemperatur in der Keimentstehungsphase wie in der Kristallwachstumsphase war die Struktur der Kristalle in der Nähe der Substrate nicht so scharfkantig wie in einiger Entfernung von der Substratoberfläche.

Beispiel 12:

Bei diesem Beispiel war das Plasma nicht gleichmässig über das Substratgitter verteilt. Durch Anlegen eines Magnetfeldes in axialer Richtung des Bogens und entsprechende Anoden- und Ionisierungskammerkonfiguration war die Plasmadichte in radialer Richtung des Bogens nach aussen hin stark abnehmend. Im Bereich geringerer Plasmadichte (ca. 50% der maximalen Plasmadichte) konnten auch Diamantschichten abgeschieden werden, jedoch waren die Parameter, die zur Abscheidung in der Diamantstruktur notwendig waren, aufgrund der unterschiedlichen Plasmadichte stark abhängig von der radialen Position der Substrate. Daher konnten wohl in einem kleinen Bereich Diamantschichten abgeschieden werden, jedoch war eine homogene Beschichtung über grössere Flächen nicht möglich.

**Patentansprüche**

1. Verfahren zur Herstellung einer Diamantschicht auf einem Gut mittels reaktivem, plasmaunterstütztem Beschichtungsverfahren, dadurch gekennzeichnet, dass

a) das Plasma mittels Gleichspannungsbogenentladung an einer Anoden/Kathodenstrecke erzeugt wird, in welche Strecke von einer Ladungsträgerquelle Ladungsträger eingebracht werden,

b) das Gut in der Kathoden/Anodenstrecke so eingebracht wird, dass die Plasmadichte entlang der zu beschichtenden Oberfläche ≥ 20% der maximalen Plasmadichte an der Anoden/Kathodenstrecke ist,

c) der Prozessdruck p wie folgt gewählt wird:

$$5Pa < p < 1000Pa,$$

d) der Entladestrom I pro zu beschichtende Gutfläche, senkrecht zur Kathoden/Anodenstrecke betrachtet, wie folgt gewählt wird:

$$0,8\ kA/m^2 \leq I.$$

2. Verfahren nach Anspruch 1, dadurch gekennzeichnet, dass der Prozessdruck p wie folgt gewählt wird:

$$10Pa \leq p \leq 100Pa.$$

3. Verfahren nach einem der Ansprüche 1 oder 2, dadurch gekennzeichnet, dass der Entladestrom I wie folgt gewählt wird:

$$4\ kA/m^2 \leq I.$$

4. Verfahren nach einem der Ansprüche 1 bis 3, dadurch gekennzeichnet, dass die Kathoden/Anodenspannung $\leq 150V$ gewählt wird.

5. Verfahren nach einem der Ansprüche 1 bis 4, dadurch gekennzeichnet, dass die Anoden/Kathodenspannung $\leq 60V$ gewählt wird.

6. Verfahren nach einem der Ansprüche 1 bis 5, dadurch gekennzeichnet, dass die Plasmadichte entlang der zu beschichtenden Oberfläche $\geq$ 60% des Maximums ist.

7. Verfahren nach einem der Ansprüche 1 bis 6, dadurch gekennzeichnet, dass ein Ableitwiderstand des Gutes auf ein vorzugsweise einstellbares Bezugspotential so gewählt wird, dass der über das Gut abfliessende Strom $I \leq 20\%$ des Entladestromes ist.

8. Verfahren nach einem der Ansprüche 1 bis 7, dadurch gekennzeichnet, dass die Behandlungstemperatur des Gutes durch Veränderung des über das Gut abfliessenden Stromes I eingestellt wird.

9. Verfahren nach einem der Ansprüche 1 bis 8, dadurch gekennzeichnet, dass die Ladungsträger durch thermische Elektronenemission eines Heissemitters erzeugt werden.

10. Verfahren nach Anspruch 9, dadurch gekennzeichnet, dass der Heissemitter als Kathode der Kathoden/Anodenstrecke geschaltet wird.

11. Verfahren nach einem der Ansprüche 1 bis 10, dadurch gekennzeichnet, dass die Prozessatmosphäre mehr als 50% Edelgas umfasst.

12. Verfahren nach Anspruch 11, dadurch gekennzeichnet, dass der Edelgasanteil grösser als 90% ist.

13. Verfahren nach einem der Ansprüche 9 oder 10, dadurch gekennzeichnet, dass die am Heissemitter emittierten Elektronen eine Temperatur $\geq$ der doppelten Gastemperatur aufweisen.

14. Verfahren nach Anspruch 13, dadurch gekennzeichnet, dass die Elektronentemperatur $\geq 10 \times$ die Gastemperatur ist.

15. Verfahren nach einem der Ansprüche 9 bis 14, dadurch gekennzeichnet, dass die Behandlungswirkungsverteilung mindestens entlang einer vorgegebenen Fläche in einem Reaktionsraum durch Vorgabe einer flächigen Verteilung des Arbeitsgaseinlasses mindestens teilweise festgelegt wird.

16. Verfahren nach einem der Ansprüche 1 bis 15, dadurch gekennzeichnet, dass die Behandlungswirkungsverteilung mindestens entlang einer vorgegebenen Fläche in einem Reaktionsraum durch Vorgabe einer zweidimensionalen Verteilung von Bogenentladungen in einem Rezipienten festgelegt wird.

17. Verfahren nach Anspruch 15, dadurch gekennzeichnet, dass die vorgegebene Fläche aequidistant zur flächigen Einlassverteilung gewählt wird und letztere eine im wesentlichen homogene Verteilung ist.

18. Verfahren nach einem der Ansprüche 15 oder 17, dadurch gekennzeichnet, dass die flächige Einlassverteilung eine Ebene ist.

19. Verfahren nach einem der Ansprüche 15, 17, 18, dadurch gekennzeichnet, dass die Einlassverteilung an einer Vielzahl von Einlassöffnungen mit Zuleitungsabschnitten vorgenommen wird und durch selektive Auslegung ihrer Querschnittsflächen und/oder Leitungsabschnittslängen und/oder ihres Beaufschlagungsdruckes und/oder ihrer Ausmündungsrichtung die Einlassverteilung festgelegt wird.

20. Verfahren nach einem der Ansprüche 15, 17 bis 19, dadurch gekennzeichnet, dass Einlass und Absaugung so angeordnet werden, dass eine im Nichtbetrieb des Beschichtungsverfahrens dazwischen erzwungene Gasströmung über einen wesentlichen Abschnitt des Rezipientinnenvolumens im wesentlichen parallel und vorzugsweise homogen ist.

21. Verfahren nach einem der Ansprüche 1 bis 20, dadurch gekennzeichnet, dass das Gut in wesentlichen Bereichen des Prozessvolumens verteilt angeordnet wird.

22. Verfahren nach einem der Ansprüche 1 bis 21, dadurch gekennzeichnet, dass die Bogenentladung durch mehrere Oeffnungen und mindestens eine ihnen gegenüberliegende Elektrode im Beschichtungsrezipienten erzeugt wird.

23. Verfahren nach einem der Ansprüche 1 bis 22, dadurch gekennzeichnet, dass die Ladungsträger durch thermische Elektronenemission erzeugt werden und durch Erzeugung einer Gasströmung im Bereich einer Thermoelektronen-emittierenden Anordnung deren Beeinträchtigung durch den Behandlungsprozess mindestens wesentlich reduziert wird.

24. Verfahren nach einem der Ansprüche 1 bis 23, dadurch gekennzeichnet, dass die Richtung der Anoden/Kathodenstrecke für die Entladung gleich zu einer im wesentlichen durch Einlass und Absaugung festgelegten Richtung für das Arbeitsgas gewählt wird.

25. Verfahren nach einem der Ansprüche 1 bis 24, dadurch gekennzeichnet, dass eine Gasabsaugung flächig verteilt vorgenommen wird.

26. Verfahren nach einem der Ansprüche 1 bis 25, dadurch gekennzeichnet, dass eine Anordnung zur flächigen Verteilung der Arbeitsgasein- und/oder -ausströmung bezüglich des Rezipienten als Elektrode für die Bogenentladung eingesetzt wird.

27. Verfahren nach einem der Ansprüche 1 bis 26, dadurch gekennzeichnet, dass mindestens eine der Elektroden für die Bogenentladung durch eine Verteilungsanordnung für den Arbeitsgaseinlass oder die Absaugung vom Innenraum des Behandlungsrezipienten getrennt wird.

28. Verfahren nach einem der Ansprüche 1 bis 27, dadurch gekennzeichnet, dass durch Veränderung über das Gut abfliessenden Stromes I dessen Temperatur gesteuert bzw. in einem Temperaturregelkreis gestellt wird.

29. Vakuumbehandlungsanlage für die Erzeugung von Diamantschichten mit einem Vakuumrezipienten, einer darin einmündenden Einlassanordnung für ein mindestens teilweise im Rezipienten zur Reaktion gebrachtes Arbeitsgas und einer Absauganordnung für gasförmige Reaktionsprodukte, dadurch gekennzeichnet, dass eine Anoden/Kathodenstrecke zur Erzeugung einer Gleichspannungs-Bogenentladung im Rezipienten vorgesehen ist, eine Oeffnungsanordnung zum Einkoppeln eines Stromes geladener Teilchen in die Strecke, und eine Halterung für zu beschichtendes Gut in der Kathoden/Anodenstrecke so angeordnet ist, dass im Betrieb die Halterung im Bereiche einer Plasmadichte liegt, die ≥ 20% der maximalen Plasmadichte der Bogenentladung ist, wobei die Halterung potential-fliegend oder mit einem Widerstandselement entkoppelt auf ein elektrisches Bezugspotential gelegt ist.

30. Anlage nach Anspruch 29, dadurch gekennzeichnet, dass die Einlassanordnung (7) für das Arbeitsgas eine Vielzahl flächig verteilter Einlassöffnungen (9) umfasst.

31. Vakuumbehandlungsanlage nach einem der Ansprüche 29 oder 30, dadurch gekennzeichnet, dass die Oeffnungsanordnung für den Teilchenstrom mehrere Verteilöffnungen (21a, 21c) zum Rezipienteninnenraum (V) umfasst zur Erzeugung einer zweidimensional verteilten Bogenentladung.

32. Anlage nach einem der Ansprüche 29 bis 31, dadurch gekennzeichnet, dass, vom Rezipienteninnenraum (V) über die Oeffnungsanordnung (21, 21a, 21c) getrennt, eine thermisch Elektronen-emittierende Anordnung (25, 25c) zur Erzeugung des Teilchenstromes vorgesehen ist.

33. Anlage nach Anspruch 30, dadurch gekennzeichnet, dass die Elektronen-emittierende Anordnung eine direkt oder indirekt beheizte Heisskathode ist.

34. Anlage nach Anspruch 31, dadurch gekennzeichnet, dass die Heisskathode eine Kathode der Anoden/Kathodenstrecke ist.

35. Anlage nach einem der Ansprüche 32 bis 34, dadurch gekennzeichnet, dass die emittierende Anordnung in einer Kammer (23, 23c) angeordnet ist, in welche eine Gasleitungsanordnung (33, 33c) einmündet.

**36.** Anlage nach einem der Ansprüche 29 bis 35, dadurch gekennzeichnet, dass die Einlassanordnung (7, 41) und die Absauganordnung (19, 19c, 72) einerseits, die Elektroden (25c, 27c, 50) für die Bogenentladung anderseits so angeordnet sind, dass im Betrieb eine Gasströmung zwischen Einlassanordnung und Absauganordnung und die Anoden/Kathodenstrecke im wesentlichen gleichgerichtet sind.

**37.** Anlage nach einem der Ansprüche 29 bis 36, dadurch gekennzeichnet, dass die Einlassanordnung (7) oder die Absaugung eine Lochplatte (11) umfasst, die gleichzeitig eine der Elektroden ist.

**38.** Anlage nach einem der Ansprüche 29 bis 37, dadurch gekennzeichnet, dass die Einlassanordnung (7) oder die Absaugung eine Lochplatte (11) umfasst, einseitig eine Kammer (13) abschliessend, und dass eine der Elektroden (50) für die Entladung darin oder daran (13) angeordnet ist.

**39.** Anlage nach einem der Ansprüche 29 bis 38, dadurch gekennzeichnet, dass die Oeffnungsanordnung für den Teilchenstrom eine Lochplatte (24) umfasst.

**40.** Anlage nach Anspruch 39, dadurch gekennzeichnet, dass die Lochplatte (24) mindestens Teil der Einlass- oder Absauganordnung ist, womit im Betrieb durch die Lochplatte sowohl der Teilchenstrom wie auch Gas fliesst.

**41.** Anlage nach einem der Ansprüche 29 bis 40, dadurch gekennzeichnet, dass die Anlage axial symmetrisch, vorzugsweise zylindrisch aufgebaut ist mit Einlassanordnung und Absauganordnung je stirnseitig und ebenso angeordneter Elektrodenanordnung für die Entladung.

**42.** Anlage nach einem der Ansprüche 29 bis 41, dadurch gekennzeichnet, dass das Widerstandselement einstellbar ist.

**43.** Anlage nach Anspruch 42, dadurch gekennzeichnet, dass das Widerstandselement ein Stellglied in einem Temperaturregelkreis für das Gut ist.

**Claims**

**1.** A process for producing a diamond layer on an object by means of a reactive, plasma-assisted coating process, characterised in that
a) the plasma is produced by means of dc voltage arc discharge at an anode/cathode path, into which path charge carriers are introduced by a charge carrier source,
b) the object is introduced into the cathode/anode path in such a way that the plasma density along the surface to be coated is $\geq$ 20% of the maximum plasma density at the anode/cathode path,
c) the process pressure p is selected as follows:

$$5Pa < p < 1000 \ Pa,$$

and

d) the discharge current I in relation to object area to be coated, when considered perpendicularly to the cathode/anode path, is selected as follows:

$$0.8 \ kA/m^2 \leq I.$$

**2.** A process according to claim 1 characterised in that the process pressure p is selected as follows:

$$10Pa \leq p \leq 100 \ Pa.$$

**3.** A process according to one of claims 1 and 2 characterized in that the discharge current I is selected as follows:

$$4 \ kA/m^2 \leq I.$$

**4.** A process according to one of claims 1 to 3 characterized in that the cathode/anode voltage is selected at $\leq$ 150 V.

**5.** A process according to one of claims 1 to 4 characterized in that the anode/cathode voltage is selected at $\leq$ 60V.

**6.** A process according to one of claims 1 to 5 characterised in that the plasma density along the surface to be coated is $\geq$ 60% of the maximum.

**7.** A process according to one of claims 1 to 6 characterised in that a leakage resistance of the object to a preferably adjustable reference potential is so selected that the current I flowing away by way of the object $\leq$ 20% of the discharge current.

**8.** A process according to one of claims 1 to 7 characterised in that the treatment temperature of the object is adjusted by varying the current I which flows away by way of the object.

9. A process according to one of claims 1 to 8 characterised in that the charge carriers are produced by thermionic electron emission of a hot emitter.

10. A process according to claim 9 characterised in that the hot emitter is connected as the cathode of the cathode/anode path.

11. A process according to one of claims 1 to 10 characterised in that the process atmosphere is are than 50% inert gas.

12. A process according to claim 11 characterised in that the proportion of inert gas is greater than 90%.

13. A process according to one of claims 9 and 10 characterised in that the electrons emitted at the hot emitter are at a temperature $\geq$ double the gas temperature.

14. A process according to claim 13 characterised in that the electron temperature is $\geq$ 10 x the gas temperature.

15. A process according to one of claims 9 to 14 characterised in that the distribution of treatment action at least along a predetermined surface in a reaction space is at least partially fixed by predetermining a distribution in respect of area of the working gas inlet.

16. A process according to one of claims 1 to 15 characterised in that the distribution of treatment action at least along a predetermined surface in a reaction space is fixed by predetermining a two-dimensional distribution of arc discharges in a container.

17. A process according to claim 15 characterised in that the predetermined surface is selected to be equidistant in relation to the inlet distribution in respect of area and the latter is a substantially homogeneous distribution.

18. A process according to one of claims 15 and 17 characterised in that the inlet distribution in respect of area is a plane.

19. A process according to one of claims 15, 17 and 18 characterised in that the inlet distribution is effected at a plurality of inlet openings with feed conduit portions and selective design of the cross-sectional areas thereof and/or conduit portion lengths and/or the pressure acting upon same and/or their discharge direction provides for determining the inlet distribution.

20. A process according to one of claims 15 and 17 to 19 characterised in that inlet and suction removal bans are so arranged that a gas flow enforced therebetween in the condition of non-operation of the coating process is substantially parallel and preferably homogeneous over a substantial portion of the internal volume of the container.

21. A process according to one of claims 1 to 20 characterized in that the object is arranged distributed in substantial regions of the process volume.

22. A process according to one of claims 1 to 21 characterised in that the arc discharge is produced through a plurality of openings and at least one electrode disposed opposite to the openings in the coating container.

23. A process according to one of claims 1 to 22 characterized in that the charge carriers are produced by thermionic electron emission and by the production of a gas flow in the region of an arrangement emitting thermionic electrons the adverse effect thereon by the treatment process is at least substantially reduced.

24. A process according to one of claims 1 to 23 characterised in that the direction of the anode/cathode path for the discharge is selected to be the same as a direction for the working gas, which is substantially determined by the inlet and the suction removal means.

25. A process according to one of claims 1 to 24 characterized in that gas suction removal is effected in such a manner as to be distributed over an area.

26. A process according to one of claims 1 to 25 characterized in that an arrangement for distribution in respect of area of the working gas inlet flow and/or discharge flow relative to the container is used as an electrode for the arc discharge.

27. A process according to one of claims 1 to 26 characterized in that at least one of the electrodes for the arc discharge is separated from the internal space of the treatment container by a distribution arrangement for the working gas inlet or the suction removal.

28. A process according to one of claims 1 to 27 characterised in that by a variation in the current I flowing away by way of the object its temperature is controlled or is set in a temperature regulating circuit.

29. A vacuum treatment installation for the production of diamond layers having a vacuum container, an inlet arrangement which opens into same for a working gas which is at least partially caused to react in the container and a suction removal arrangement for gaseous reaction products, characterised in that there is provided an anode/cathode path for producing a dc voltage arc discharge in the container, an opening arrangement for coupling a stream of charged particles into the path, and a holder for an object to be coated is so arranged in the cathode/anode path that in operation the holder is disposed in the region of a plasma density which is ≥ 20% of the maximum plasma density of the arc discharge, wherein the holder is connected in flying-potential relationship or decoupled with a resistance element to an electrical reference potential.

30. An installation according to claim 29 characterised in that the inlet arrangement (7) for the working gas includes a plurality of inlet openings (9) which are distributed in respect of area.

31. A vacuum treatment installation according to one of claims 29 and 30 characterised in that the opening arrangement for the stream of particles includes a plurality of distribution openings (21a, 21c) towards the internal space (V) of the container for producing a two-dimensionally distributed arc discharge.

32. An installation according to one of claims 29 to 31 characterised in that, separated from the internal space (V) of the container by way of the opening arrangement (21, 21a, 21c), there is provided an arrangement (25, 25c) for thermionically emitting electrons, for producing the stream of particles.

33. An installation according to claim 30 characterised in that the electron-emitting arrangement is a directly or indirectly heated hot cathode.

34. An installation according to claim 31 characterised in that the hot cathode is a cathode of the anode/cathode path.

35. An installation according to one of claims 32 to 34 characterised in that the emitting arrangement is disposed in a chamber (23, 23c) into which a gas conduit arrangement (33, 33c) opens.

36. An installation according to one of claims 29 to 35 characterised in that the inlet arrangement (7, 41) and the suction removal arrangement (19, 19c, 72) on the one hand and the electrodes (25c, 27c, 50) for the arc discharge on the other hand are so arranged that in operation a gas flow between the inlet arrangement and the suction removal arrangement and the anode/cathode path are substantially in the same direction.

37. An installation according to one of claims 29 to 36 characterised in that the inlet arrangement (7) or the suction removal means includes an apertured plate (11) which at the same time is one of the electrodes.

38. An installation according to one of claims 29 to 37 characterised in that the inlet arrangement (7) or the suction removal means includes an apertured plate (11), closing off a chamber (13) at one side, and that one of the electrodes (50) is arranged for the discharge therein or thereat (13).

39. An installation according to one of claims 29 to 38 characterised in that the opening arrangement for the particle stream includes an apertured plate (24).

40. An installation according to claim 39 characterised in that the apertured plate (24) is at least part of the inlet or suction removal arrangement, whereby in operation both the particle stream and also gas flows through the apertured plate.

41. An installation according to one of claims 29 to 40 characterised in that the installation is of an axially symmetrical and preferably cylindrical configuration with inlet arrangement and suction removal arrangement at the respective ends and a likewise arranged electrode arrangement for the discharge.

42. An installation according to one of claims 29 to 41 characterised in that the resistance element is adjustable.

43. An installation according to claim 42 characterised in that the resistance element is a control member in a temperature regulating circuit for the object.

**Revendications**

1. Procédé pour la fabrication d'une couche de diamant sur un produit au moyen d'un procédé réactif de revêtement à l'aide d'un plasma, caractérisé en ce que

a) le plasma est produit à l'aide d'une décharge en arc à tension continue au niveau d'un intervalle anode/cathode dans lequel des porteurs de charge sont introduits à partir d'une source de porteurs de charge,

b) le produit prévu dans l'intervalle cathode/anode est placé de telle sorte que la densité de plasma le long de la surface à revêtir soit ≥ 20% de la densité de plasma maximale au niveau de l'intervalle anode/cathode,

c) la pression de procédé p est choisie pour que :

5 Pa < p < 1000 Pa

d) le courant de décharge I par surface de produit à revêtir, considéré perpendiculairement à l'intervalle cathode/anode, est choisi pour que :

$0,8 \text{ kA/m}^2 \leq I$

2. Procédé selon la revendication 1, caractérisé en ce que la pression de procédé p est choisie pour que :

$10 \text{ Pa} \leq p \leq 100 \text{ Pa}$

3. Procédé selon l'une des revendications 1 ou 2, caractérisé en ce que le courant de décharge I est choisi pour que :

$4 \text{ kA/m}^2 \leq I$

4. Procédé selon l'une des revendications 1 à 3, caractérisé en ce que la tension cathode/anode est choisie pour être ≤ 150 V.

5. Procédé selon l'une des revendications 1 à 4, caractérisé en ce que la tension anode/cathode est choisie pour être ≤ 60 V.

6. Procédé selon l'une des revendications 1 à 5, caractérisé en ce que la densité de plasma le long de la surface à revêtir est ≥ 60% du maximum.

7. Procédé selon l'une des revendications 1 à 6, caractérisé en ce qu'une résistance de fuite du produit est choisie à un potentiel de préférence réglable, de telle sorte que le courant I s'écoulant sur le produit soit ≤ 20% du courant de décharge.

8. Procédé selon l'une des revendications 1 à 7, caractérisé en ce que la température de traitement du produit est réglée grâce à une variation du courant I s'écoulant sur le produit.

9. Procédé selon l'une des revendications 1 à 8, caractérisé en ce que les porteurs de charge sont produits par une émission thermique d'électrons à partir d'un émetteur chaud.

10. Procédé selon la revendication 9, caractérisé en ce que l'émetteur chaud est monté comme cathode de l'intervalle cathode/anode.

11. Procédé selon l'une des revendications 1 à 10, caractérisé en ce que l'atmosphère de procédé contient plus de 50% de gaz rare.

12. Procédé selon la revendication 11, caractérisé en ce que la proportion de gaz rare est supérieure à 90%.

13. Procédé selon l'une des revendications 9 à 10, caractérisé en ce que les électrons émis au niveau de l'émetteur chaud présentent une température ≥ au double de la température du gaz.

14. Procédé selon la revendication 13, caractérisé en ce que la température d'électrons ≥ 10 × la température du gaz.

15. Procédé selon l'une des revendications 9 à 14, caractérisé en ce que la répartition d'action de traitement est au moins en partie déterminée au moins le long d'une surface prédéfinie, dans un espace de réaction, par la définition préalable d'une répartition plane de l'admission du gaz de travail.

16. Procédé selon l'une des revendications 1 à 15, caractérisé en ce que la répartition d'action de traitement est déterminée au moins le long d'une surface prédéfinie, dans un espace de réaction, par la définition préalable d'une répartition à deux dimensions de décharges en arc dans un récipient.

17. Procédé selon la revendication 15, caractérisé en ce que la surface prédéfinie est choisie pour être équidistante de la répartition plane d'admission, et cette répartition est essentiellement homogène.

18. Procédé selon l'une des revendications 15 ou 17, caractérisé en ce que la répartition d'admission plane consiste en un plan.

**19.** Procédé selon l'une des revendications 15, 17, 18, caractérisé en ce que la répartition d'admission est réalisée au niveau d'une multiplicité d'orifices d'admission comportant des sections d'amenée, et la répartition d'admission est déterminée par une étude sélective de leurs surfaces de section transversale et/ou des longueurs de section de conduite et/ou de leur pression de contrainte et/ou de leur sens de sortie.

**20.** Procédé selon l'une des revendications 15, 17 à 19, caractérisé en ce que l'admission et l'aspiration sont disposées de telle sorte qu'un courant de gaz forcé entre elles lors de l'arrêt du procédé de revêtement est sensiblement parallèle et de préférence homogène sur une section importante du volume intérieur du récipient.

**21.** Procédé selon l'une des revendications 1 à 20, caractérisé en ce que le produit est réparti dans des zones essentielles du volume de procédé.

**22.** Procédé selon l'une des revendications 1 à 21, caractérisé en ce que la décharge en arc est produite par plusieurs orifices et au moins une électrode située en face de ces ouvertures, dans le récipient de revêtement.

**23.** Procédé selon l'une des revendications 1 à 22, caractérisé en ce que les porteurs de charge sont produits par une émission thermique d'électrons, et grâce à la production d'un courant de gaz dans la zone d'un dispositif émettant des électrons émis par voie thermique, la dégradation de celui-ci par le processus de traitement est au moins sensiblement réduite.

**24.** Procédé selon l'une des revendications 1 à 23, caractérisé en ce que le sens choisi pour l'intervalle anode/cathode pour la décharge est le même qu'un sens déterminé essentiellement par l'admission et l'aspiration, pour le gaz de travail.

**25.** Procédé selon l'une des revendications 1 à 24, caractérisé en ce qu'une aspiration de gaz est réalisée suivant une répartition plane.

**26.** Procédé selon l'une des revendications 1 à 25, caractérisé en ce qu'un dispositif pour la répartition plane de l'entrée et/ou de la sortie du gaz de travail par rapport au récipient est utilisé comme électrode pour la décharge en arc.

**27.** Procédé selon l'une des revendications 1 à 26, caractérisé en ce que l'une au moins des électrodes prévues pour la décharge en arc est séparée de l'intérieur du récipient de traitement par un dispositif de répartition pour l'admission du gaz de travail ou l'aspiration.

**28.** Procédé selon l'une des revendications 1 à 27, caractérisé en ce que grâce à une variation du courant I s'écoulant sur le produit, la température de celui-ci est commandée ou réglée dans un circuit régulateur de température.

**29.** Installation de traitement sous vide pour la production de couches de diamant, comprenant un récipient sous vide, un dispositif d'admission, débouchant dans celui-ci, pour un gaz de travail amené en réaction au moins partiellement dans le récipient, et un dispositif d'aspiration pour les produits de réaction gazeux, caractérisée en ce qu'il est prévu un intervalle anode/cathode pour la production d'une décharge en arc a tension continue dans le récipient, et un dispositif d'ouverture pour l'injection d'un courant de particules chargées dans ledit intervalle et un support pour le produit à revêtir sont disposés dans l'intervalle cathode/anode de telle sorte que lors du fonctionnement, le support se trouve dans la zone d'une densité de plasma qui soit ≥ 20% de la densité de plasma maximale de la décharge en arc, le support étant mis à un potentiel flottant ou, découplé, à un potentiel de référence électrique à l'aide d'un élément de résistance.

**30.** Installation selon la revendication 29, caractérisée en ce que le dispositif d'admission (7) prévu pour le gaz de travail comprend une multiplicité d'orifices d'admission (9) répartis de façon plane.

**31.** Installation de traitement sous vide selon l'une des revendications 29 ou 30, caractérisée en ce que le dispositif d'ouverture prévu pour le courant de particules comprend plusieurs orifices de répartition (21a, 21c) dirigés vers l'intérieur (V) du récipient, en vue de la production d'une décharge en arc répartie à deux dimensions.

**32.** Installation selon l'une des revendications 29 à 31, caractérisée en ce qu'il est prévu, séparé de l'intérieur (V) du récipient par l'intermédiaire du dispositif d'ouverture (21, 21a, 21c), un dispositif (25, 25c) émettant des électrons par voie thermique pour la production du courant de particules.

**33.** Installation selon la revendication 30, caractérisée en ce que le dispositif émettant des électrons est une cathode chaude chauffée directement ou indirectement.

**34.** Installation selon la revendication 31, caractérisée en ce que la cathode chaude est une cathode de l'intervalle anode/cathode.

**35.** Installation selon l'une des revendications 32 à 34, caractérisée en ce que le dispositif d'émission est disposé dans une chambre (23, 23c) dans laquelle débouche un dispositif d'amenée de gaz (33, 33c).

**36.** Installation selon l'une des revendications 29 à 35, caractérisée en ce que le dispositif d'admission (7, 41) et le dispositif d'aspiration (19, 19c, 72), d'une part, et les électrodes (25c, 27c, 50) pour la décharge en arc, d'autre part, sont disposés pour que, lors du fonctionnement, un courant de gaz entre le dispositif d'admission et le dispositif d'aspiration et l'intervalle anode/cathode soient dirigés sensiblement dans le même sens.

**37.** Installation selon l'une des revendications 29 à 36, caractérisée en ce que le dispositif d'admission (7) ou l'aspiration comprend une plaque perforée (11) qui définit en même temps l'une des électrodes.

**38.** Installation selon l'une des revendications 29 à 37, caractérisée en ce que le dispositif d'admission (7) ou l'aspiration comprend une plaque perforée (11) qui ferme unilatéralement une chambre (13), et en ce que l'une des électrodes (50) pour la décharge est disposée dans celle-ci ou contre celle-ci (13).

**39.** Installation selon l'une des revendications 29 à 38, caractérisée en ce que le dispositif d'ouverture pour le courant de particules comprend une plaque perforée (24).

**40.** Installation selon la revendication 39, caractérisée en ce que la plaque perforée (24) forme au moins une partie du dispositif d'admission ou d'aspiration, moyennant quoi, pendant le fonctionnement, le courant de particules et le gaz s'écoulent tous les deux à travers la plaque perforée.

**41.** Installation selon l'une des revendications 29 à 40, caractérisée en ce que l'installation présente une structure axialement symétrique, de préférence cylindrique, le dispositif d'admission et le dispositif d'aspiration étant disposés sur les faces frontales, ainsi que le dispositif d'électrodes pour la décharge.

**42.** Installation selon l'une des revendications 29 à 41, caractérisée en ce que l'élément de résistance est réglable.

**43.** Installation selon la revendication 42, caractérisée en ce que l'élément de résistance est un organe de réglage dans un circuit régulateur de température prévu pour le produit.

EP 0 478 909 B1

FIG. 1

FIG. 1a

FIG.2

FIG.3

FIG. 4

FIG.5

FIG.6

FIG.7